# EUROPEAN PATENT SPECIFICATION

(11) **EP 4 428 638 B1**
(45) Date of publication and mention of the grant of the patent: **04.03.2026**
(21) Application number: 22885264.6
(22) Date of filing: 02.08.2022
(51) Int. Cl.: G05B 19/042, G05B 19/05, H03F 1/52, H03F 3/45

(54) **OUTPUT CONTROL CIRCUIT, CONTROLLER, AND AIR CONDITIONER**
AUSGANGSSTEUERSCHALTUNG, STEUERGERÄT UND KLIMAANLAGE
CIRCUIT DE COMMANDE DE SORTIE, DISPOSITIF DE COMMANDE ET CLIMATISEUR

(30) Priority: 01.11.2021 CN 202111284433
(43) Date of publication of application: 11.09.2024
(73) Proprietor: Shanghai Kong Intelligent Building Co., Ltd, Shanghai 200080 (CN); GD Midea Heating & Ventilating Equipment Co., Ltd., Foshan, Guangdong 528311 (CN)
(72) Inventor: ZHAO, Zhen, Shanghai 200080 (CN); YANG, Dayou, Shanghai 200080 (CN); YAN, Jie, Shanghai 200080 (CN)
(74) Representative: Ran, Handong
(86) International application number: PCT/CN2022/109802
(87) International publication number: WO 2023/071364

(56) References cited:
- CN-A- 103 616 827
- CN-A- 108 062 054
- CN-A- 109 861 649
- CN-A- 114 137 865
- CN-U- 203 616 592
- CN-U- 209 388 151
- CN-U- 216 561 500
- JP-A- H08 316 742
- US-A1- 2019 179 283

## Description

### FIELD

The present disclosure relates to the field of electronic technology, particularly relates to an output control circuit, a controller and an air conditioner.

### BACKGROUND

With the rapid development of industrial automation, it has been increasing applied of a controller like Programmable Logic Controller (PLC) and a Direct Digital Control (DDC) in various fields such as industry, transportation, and buildings. With the intelligentization upgrading of the controller, there is a higher function demand on an output control circuit of the controller, for example, switching different functions of the output control circuit as desired, achieving various signal outputs such as an output with a digital quantity and an output with an analog quantity.

Therefore, it has become an urgent problem to be solved on how to enhance universality, safety, and reliability for the output control circuit. US2019179283A1 relates generally to detecting a short-circuit event which may occur in an industrial control apparatus.

### SUMMARY

Aspects of the invention are set out in the claims. In the following, each of the described methods, apparatuses, embodiments, examples, and aspects, which do not fully correspond to the invention as defined in the claims is thus not according to the invention and is, as well as the whole following description, present for illustration purposes only or to highlight specific aspects or features of the claims. Embodiments not falling under the scope of the claims should be interpreted as examples useful for understanding the invention. The present disclosure aims to solve at least one of the technical problems in the related art to a certain degree.

In view of the above, a first object of the present disclosure is to provide an output control circuit, so as to further achieve intelligentization and remote configuration by software control, enabling the controller to switch different functions of an output signal, and enhancing universality, safety, and reliability for the output control circuit.

A second object of the present disclosure is to provide a controller.

A third object of the present disclosure is to provide an air conditioner.

In order to achieve the above objects, in a first aspect, the present disclosure provides in embodiments an output control circuit, circuit for a controller, wherein the output control circuit is configured to be arranged in the controller, and the output control circuit includes: a signal input end, configured to input a voltage input signal; a first amplification module, wherein a first input end of the first amplification module is connected to the signal input end; a first power module, wherein a first end of the first power module is connected to an output end of the first amplification module; and a second end of the first power module is connectable to a first direct-current voltage source; a first resistor, wherein a first end of the first resistor is connected to a third end of the first power module; a second amplification module, wherein a first input end of the second amplification module is connected to the first end of the first resistor; and a second input end of the second amplification module is connected to a second end of the first resistor; a switch module, wherein the switch module is connected to the second end of the first resistor, an output end of the second amplification module, and a second input end of the first amplification module, respectively; and the switch module is configured to switch between a first connection and a second connection, wherein the first connection is between the second end of the first resistor and the second input end of the first amplification module; and the second connection is between the output end of the second amplification module and the second input end of the first amplification module; and a signal output end, wherein the signal output end is connected to the second end of the first resistor, and configured to output a digital quantity of a first voltage output signal, an analog quantity of a second voltage output signal, and an analog quantity of a current output signal.

According to the invention, the output control circuit includes: the signal output end, the signal input end, the first amplification module, the first power module, the first resistor, the second amplification module and the switch module as defined in claim 1. As such, the output control circuit further achieves intelligentization and remote configuration by software control, thus enabling the controller to switch different functions of the output signal, and enhancing universality, safety, and reliability for the output control circuit.

In addition, the output control circuit provided in embodiments of the first aspect of the present disclosure may further have the following additional technical features.

In an embodiment of the present disclosure, the first amplification module includes a first operational amplifier, wherein a non-inverting input end of the first operational amplifier is connected to the signal input end; and an output end of the first operational amplifier is connected to the first end of the first power module; a first capacitor, wherein a first end of the first capacitor is connected to the output end of the first operational amplifier, and a second end of the first capacitor is connected to an inverting input end of the first operational amplifier; and a second resistor, wherein a first end of the second resistor is connected to the inverting input end of the first operational amplifier, and a second end of the second resistor is connected to the switch module.

In an embodiment of the present disclosure, the output control circuit further includes an overcurrent protection module, wherein the second end of the first power module is connected to the first direct-current voltage source through the overcurrent protection module.

In an embodiment of the present disclosure, the overcurrent protection module includes: a voltage stabilizer or current limiter, wherein a first end of the voltage stabilizer or current limiter is connected to the first direct-current voltage source; and a second end of the voltage stabilizer or current limiter is connected to the second end of the first power module; and a third resistor, wherein the second end of the voltage stabilizer or current limiter is connected to a third end of the voltage stabilizer or current limiter through the third resistor.

In an embodiment of the present disclosure, the second amplification module includes: a fourth resistor; a fifth resistor; a second operational amplifier, wherein a non-inverting input end of the second operational amplifier is connected to the first end of the first resistor through the fourth resistor; an inverting input end of the second operational amplifier is connected to the second end of the first resistor through the fifth resistor; and an output end of the second operational amplifier is connected to the switch module; a sixth resistor, wherein a first end of the sixth resistor is grounded; a second end of the sixth resistor is connected to the non-inverting input end of the second operational amplifier; a seventh resistor, wherein a first end of the seventh resistor is connected to the output end of the second operational amplifier; and a second end of the seventh resistor is connected to the inverting input end of the second operational amplifier; and a second capacity, wherein a first end of the second capacitor is connected to the output end of the second operational amplifier; and a second end of the second capacitor is connected to the inverting input end of the second operational amplifier.

In an embodiment of the present disclosure, the switch module includes: a first switch unit, wherein the first switch unit is connected to the second end of the first resistor and the second input end of the first amplification module, respectively; a second switch unit, wherein the second switch unit is connected to the output end of the second amplification module and the second input end of the first amplification module, respectively; and a control unit, wherein the control unit is connected to the first switch unit and the second switch unit, respectively; the control unit is configured to: in response to a control signal inputted, control the first switch unit to enable or disenable the first connection between the second end of the first resistor and the second input end of the first amplification module; or control the second switch unit to enable or disenable the second connection between the output end of the second amplification module and the second input end of the first amplification module.

In an embodiment of the present disclosure, the first switch unit includes a first solid-state relay, wherein an input end of the first solid-state relay is connected to the second end of the first resistor; an output end of the first solid-state relay is connected to the second input end of the first amplification module; an input control end of the first solid-state relay is connected to the control unit; and an output control end of the first solid-state relay is grounded.

In an embodiment of the present disclosure, the second switch unit includes a second solid-state relay, wherein an input end of the second solid-state relay is connected to the output end of the second amplification module; an output end of the second solid-state relay is connected to the second input end of the first amplification module; an input control end of the second solid-state relay is connected to the control unit; and an output control end of the second solid-state relay is grounded.

In an embodiment of the present disclosure, the control unit includes: a control signal input end, configured to input the control signal; a first transistor, wherein a control end of the first transistor is connected to the control signal input end; a first end of the first transistor is connected to the first switch unit; and a second end of the first transistor is grounded; an eighth resistor, wherein a first end of the eighth resistor is connected to a second direct-current voltage source; and a second end of the eighth resistor is connected to the first end of the first transistor; and a second transistor, wherein a control end of the second transistor is connected to the control signal input end; a first end of the second transistor is connected to a third direct-current voltage source; and a second end of the second transistor is connected to the second switch unit.

In an embodiment of the present disclosure, the output control circuit further includes a diode, wherein a positive electrode of the diode is grounded; and a negative electrode of the diode is connected to the signal output end.

In an embodiment of the present disclosure, the output control circuit further includes a filtration module, wherein the first input end of the first amplification module is connected to the signal input end through the filtration module.

In an embodiment of the present disclosure, the output control circuit further includes: a second power module, wherein a first end of the second power module is connected to the output end of the first amplification module; and a second end of the second power module is connected to the second end of the first power module; and a ninth resistor, wherein a first end of the ninth resistor is connected to a third end of the second power module; and a second end of the ninth resistor is connected to the signal output end, wherein the second amplification module further includes: a tenth resistor, wherein a first end of the tenth resistor is connected to the first end of the ninth resistor; and a second end of the tenth resistor is connected to the non-inverting input end of the second operational amplifier.

To achieve the above objects, in a second aspect, the present disclosure provides in embodiments a controller, including the output control circuit as described in any of the above embodiments of the first aspect of the present disclosure.

According to embodiments of the present disclosure, the controller further achieves intelligentization and remote configuration by software control, enabling the controller to switch different functions of the output signal, and enhancing universality, safety, and reliability for the output control circuit.

To achieve the above objects, in a third aspect, the present disclosure provides in embodiments an air conditioner, including the controller as described in any of the above embodiments of the second aspect of the present disclosure.

According to embodiments of the present disclosure, the air conditioner further achieves intelligentization and remote configuration by software control, enabling the controller to switch different functions of the output signal, and enhancing universality, safety, and reliability for the output control circuit

The additional aspects and advantages of the present disclosure will be partially provided in the following description, which will become apparent from the following description or learned through the practice of the present disclosure.

### BRIEF DESCRIPTION OF THE DRAWINGS

The additional aspects and advantages of the present disclosure will be partially provided in the following description, which will become apparent from the following description or learned through the practice of the present disclosure.
Figure 1 is a schematic diagram showing an output control circuit according to an embodiment of the present disclosure;
Figure 2 is a schematic diagram showing an overcurrent protection module of an output control circuit according to an embodiment of the present disclosure;
Figure 3 is a schematic diagram showing a first amplification module of an output control circuit according to an embodiment of the present disclosure;
Figure 4 is a schematic diagram showing a second amplification module of an output control circuit according to an embodiment of the present disclosure;
Figure 5 is a schematic diagram showing a switch module of an output control circuit according to an embodiment of the present disclosure;
Figure 6 is a schematic diagram showing a control unit of an output control circuit according to an embodiment of the present disclosure;
Figure 7 is a simplified circuit diagram showing an output control circuit in a voltage output mode according to an embodiment of the present disclosure;
Figure 8 is a simplified circuit diagram showing an output control circuit in a current output mode according to an embodiment of the present disclosure;
Figure 9 is an overall schematic diagram showing an output control circuit according to an embodiment of the present disclosure;
Figure 10 is an overall schematic diagram showing an output control circuit according to another embodiment of the present disclosure;
Figure 11 is a block diagram showing a controller according to an embodiment of the present disclosure; and
Figure 12 is a block diagram showing an air conditioner according to an embodiment of the present disclosure; and

### DETAILED DESCRIPTION

Reference will be made in details to embodiments of the present disclosure. The same or similar elements and the elements having same or similar functions are denoted by like reference numerals throughout the descriptions. The embodiments described herein with reference to drawings are explanatory, illustrative, and used to generally understand the present disclosure. The embodiments shall not be construed to limit the present disclosure.

With reference to the accompany drawings, an output control circuit, a controller, and an air conditioner in embodiments of the present disclosure are described below.

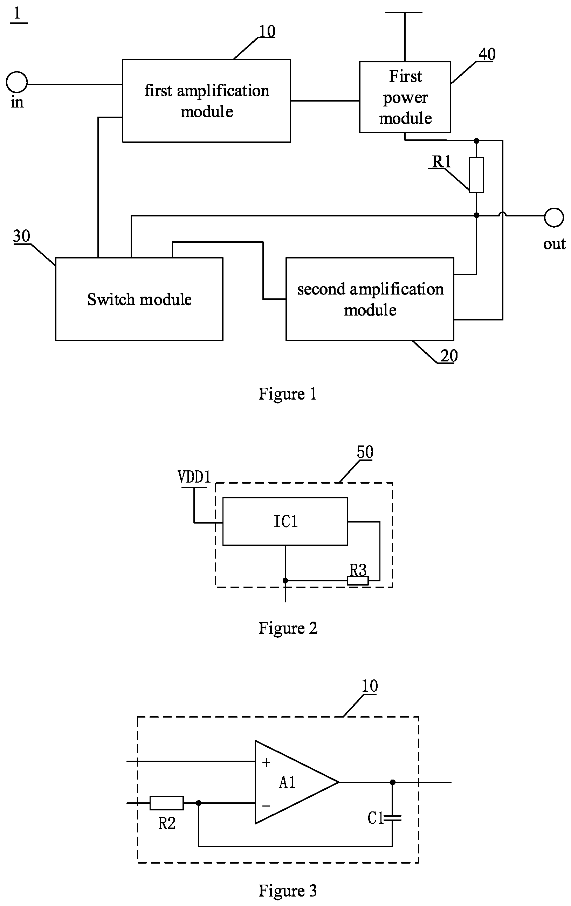

Figure 1 is a schematic diagram showing an output control circuit according to an embodiment of the present disclosure.

As shown in Figure 1, in an embodiment of the present disclosure, the output control circuit (1) may specifically include: a signal input end (in), a signal output end (out), a first amplification module (10), a first resistor (R1), a second amplification module (20), a switch module (30), and a first power module (40).

In specific, the signal input end (in) is configured to input a voltage input signal, for example a voltage input signal with an analog quantity at 0-10 V, or a voltage input signal with a digital quantity at 12 V. The first amplification module (10) includes a first input end, a second input end and an output end, where the first input end of the first amplification module (10) is connected to the signal input end (in); the second input end of the first amplification module (10) is connected to the switch module (30), and the output end of the first amplification module (10) is connected to a first end of the first power module (40), where a second end of the first power module (40) is connected to a first direct-current power supply VDD1 (such as a direct-current power supply at 12 V to 14 V); and a third end of the first power module (40) is connected to a first end of the first resistor (R1), where a second end of the first resistor (R1) is connected to the signal output end (out) and the switch module (30), where the first amplification module (10) may be configured to amplify the voltage input signal, for example, when the voltage input signal is lower than 10 V, the first amplification module (10) may output an amplified voltage signal at 10 V for the first end of the first power module (40). The second amplification module (20) includes a first input end, a second input end and an output end, where the first input end of the second amplification module (20) is connected to the first end of the first resistor (R1); the second input end of the second amplification module (20) is connected to the second end of the first resistor (R1); and the output end of the second amplification module (20) is connected to the switch module (30). The switch module (30) is configured to switch between a first connection and a second connection, wherein the first connection is between the second end of the first resistor (R1) and the second input end of the first amplification module (10), and the second connection is between the output end of the second amplification module (20) and the second input end of the first amplification module (10). The signal output end (out) is configured to output a digital quantity of a first voltage output signal, an analog quantity of a second voltage output signal, and an analog quantity of a current output signal. In specific, the digital quantity of the first voltage output signal may be a voltage output signal at 12 V; the analog quantity of the second voltage output signal may be a voltage output signal at 0-10 V; and the analog quantity of the current output signal may be a current output signal at 0-20 mA.

For example, when it is required to output the analog quantity of the second voltage output signal (such as the voltage output signal at 0-10 V) from the signal output end (out), the voltage input signal inputted from the signal input end (in) is controlled to be the voltage input signal with the analog quantity at 0-10 V; and the first connection between the second end of the first resistor (R1) and the second input end of the first amplification module (10) is enabled; while the second connection between the output end of the second amplification module (20) and the second input end of the first amplification module (10) is disenabled, accordingly the first amplification module (10) and the first power module (40) constitute an emitter follower circuit, so that the analog quantity of the second voltage output signal (such as the voltage output signal at 0-10 V) is outputted from the signal output end (out).

When it is required to output the digital quantity of the first voltage output signal (such as the voltage output signal at 12 V) from the signal output end (out), the voltage input signal inputted from the signal input end (in) is controlled to be the voltage input signal with the digital quantity at 12 V; and similarly, the first connection between the second end of the first resistor (R1) and the second input end of the first amplification module (10) is enabled; while the second connection between the output end of the second amplification module (20) and the second input end of the first amplification module (10) is disenabled, accordingly the first amplification module (10) and the first power module (40) constitute the emitter follower circuit, so that the digital quantity of the first voltage output signal (such as the voltage output signal at 12 V) is outputted from the signal output end (out).

When it is required to output the analog quantity of the current output signal (such as the current output signal at 0-20 mA) from the signal output end (out), the voltage input signal inputted from the signal input end (in) is controlled to be the voltage input signal with the analog quantity at 0-10 V; and the first connection between the second end of the first resistor (R1) and the second input end of the first amplification module (10) is disenabled; while the second connection between the output end of the second amplification module (20) and the second input end of the first amplification module (10) is enabled, so that the analog quantity of the current output signal (such as the current output signal at 0-20 mA) is outputted from the signal output end (out).

As such, the output control circuit, by means of controlling the output control circuit with software, further achieves intelligentization and remote configuration, thus enabling the controller to switch different functions of the output signal, and enhancing universality, safety, and reliability for the output control circuit.

With reference to Figures 2 to 9, the output control circuit is specifically illustrated below.

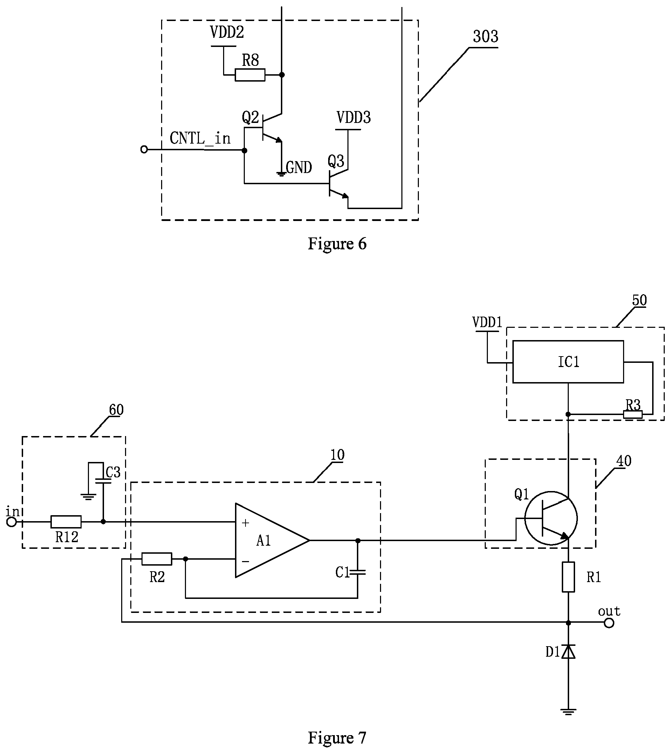

It should be noted that the first power module (40) may be composed of a triode or a Metal-Oxide-Semiconductor (MOS) transistor, which is not limited herein particularly. In embodiments of the present disclosure as shown in Figures 7-9, for convenient illustration, illustration is made by taking a first triode (Q1) serving as the first power module (40) as an example, where a base electrode of the first triode (Q1) serves as the first end of the first power module (40); a collecting electrode of the first triode (Q1) serves as the second end of the first power module (40); and an emitting electrode of the first triode (Q1) serves as the third end of the first power module (40).

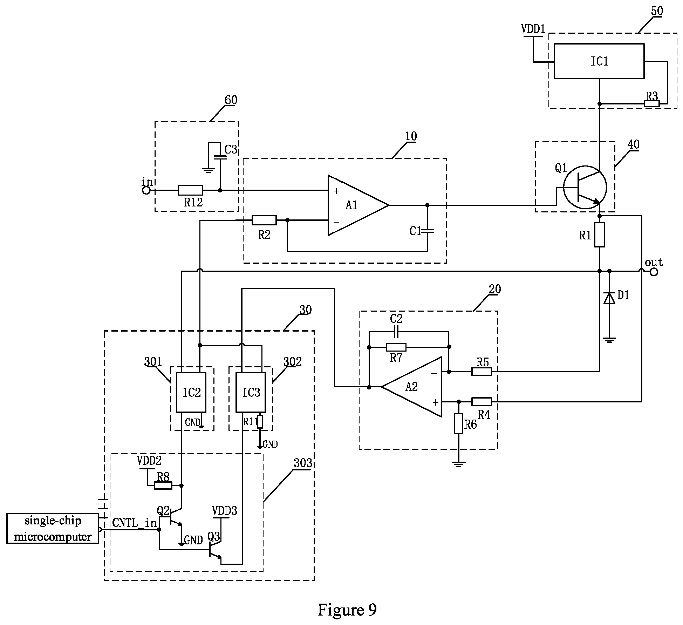

As shown in Figures 2 and 9, the output control circuit (1) may further include an overcurrent protection module (50), where the first triode (Q1) is connected to the first direct-current power supply VDD1 through the overcurrent protection module (50), thereby providing overcurrent protection on the first triode (Q1) upon a short circuit of the signal output end (out) due to user's misoperation.

As a possible embodiment, as shown in Figure 2, the overcurrent protection module (50) may include a voltage stabilizer or current limiter (IC1) and a third resistor (R3), where the voltage stabilizer or current limiter (IC1) is a three-end voltage stabilizer or current limiter, a first end of the voltage stabilizer or current limiter (IC1) is connected to the first direct-current voltage source VDD1, a second end of the voltage stabilizer or current limiter (IC1) is connected to the collecting electrode of the first triode (Q1); and the second end of the voltage stabilizer or current limiter (IC1) is connected to a third end of the voltage stabilizer or current limiter (IC1) through the third resistor (R3).

As shown in Figures 3 and 9, the first amplification module (10) may include: a first operational amplifier (A1), a first capacitor (C1), and a second resistor (R2). In specific, a non-inverting input end of the first operational amplifier (A1), serving as the first input end of the first amplification module (10), is connected to the signal input end (in); an output end of the first operational amplifier (A1), serving as the output end of the first amplification module (10), is connected to the base electrode of the first triode (Q1); an inverting input end of the first operational amplifier (A1), serving as the second input end of the first amplification module (10), is connected to a first end of the second resistor (R2); and a second end of the second resistor (R2) is connected to the switch module (30). A first end of the first capacitor (C1) is connected to the output end of the first operational amplifier (A1); and a second end of the first capacitor (C1) is connected to the inverting input end of the first operational amplifier (A1).

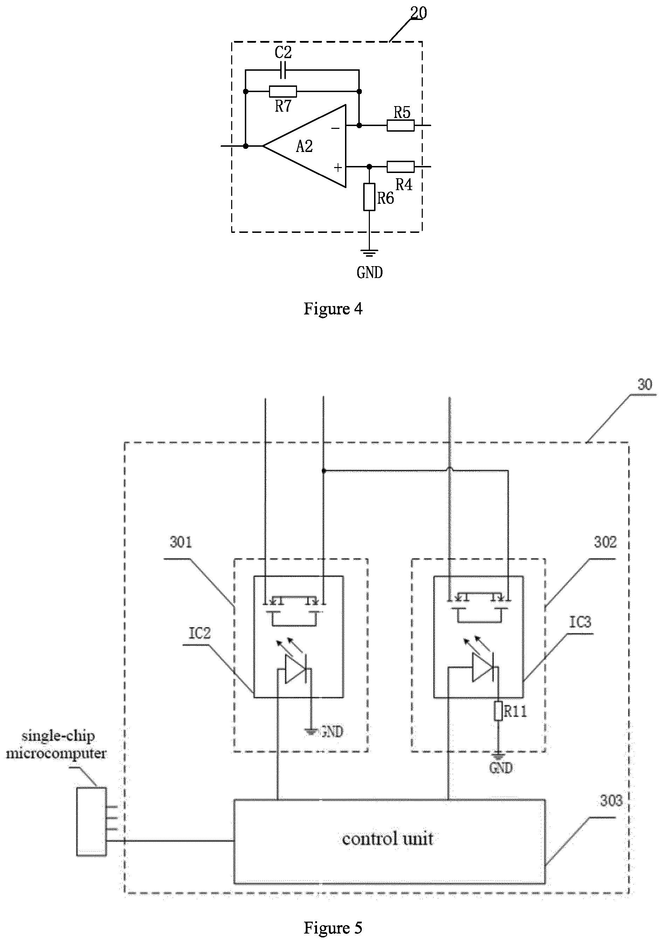

As shown in Figures 4 and 9, the second amplification module (20) may include: a fourth resistor (R4), a fifth resistor (R5), a second operational amplifier (A2), a sixth resistor (R6), a seventh resistor (R7), and a second capacitor (C2). In specific, a non-inverting input end of the second operational amplifier (A2) is connected to a first end of the fourth resistor (R4); a second end of the fourth resistor (R4), serving as the first input end of the second amplification module (20), is connected to the first end of the first resistor (R1); an inverting input end of the second operational amplifier (A2) is connected to a first end of the fifth resistor (R5); a second end of the fifth resistor (R5), serving as the second input end of the second amplification module (20), is connected to the second end of the first resistor (R1); and an output end of the second operational amplifier (A2), serving as the output end of the second amplification module (20), is connected to the switch module (30). A first end of the sixth resistor (R6) is grounded (GND); and a second end of the sixth resistor (R6) is connected to the non-inverting input end of the second operational amplifier (A2). A first end of the seventh resistor (R7) is connected to the output end of the second operational amplifier (A2); and a second end of the seventh resistor (R7) is connected to the inverting input end of the second operational amplifier (A2). A first end of the second capacitor (C2) is connected to the output end of the second operational amplifier (A2); and a second end of the second capacitor (C2) is connected to the inverting input end of the second operational amplifier (A2).

As shown in Figures 5 and 9, the switch module (30) may include: a first switch unit (301), a second switch unit (302), and a control unit (303). In specific, the second end of the first resistor (R1) is connected to the switch module (30), specifically may be connected to the first switch unit (301) in the switch module (30). The second input end of the first amplification module (10) is connected to the switch module (30), specifically may be connected to the first switch unit (301) and the second switch unit (302) in the switch module (30). The output end of the second amplification module (20) is connected to the switch module (30), specifically may be connected to the second switch unit (302) in the switch module (30). The control unit (303) is connected to the first switch unit (301) and the second switch unit (302) respectively, and configured to: in response to the control signal inputted, control the first switch unit (301) to enable or disenable the first connection between the second end of the first resistor (R1) and the second input end of the first amplification module (10); and control the second switch unit (302) to enable or disenable the second connection between the output end of the second amplification module (20) and the second input end of the first amplification module (10).

In an embodiment of the present disclosure, the first switch unit (301) may include, but not limited to, a first solid-state relay (IC2), and etc., where the first solid-state relay (IC2) includes an input end, an output end, an input control end, and an output control end. As shown in Figures 5 and 9, in the first switch unit (301), the input end of the first solid-state relay (IC2) is connected to the second end of the first resistor (R1); the output end of the first solid-state relay (IC2) is connected to the second input end of the first amplification module (10); the input control end of the first solid-state relay (IC2) is connected to the control unit (303); and the output control end of the first solid-state relay (IC2) is grounded (GND).

In an embodiment of the present disclosure, the second switch unit (302) may include, but not limited to, a second solid-state relay (IC3), and etc., where the second solid-state relay (IC3) includes an input end, an output end, an input control end, and an output control end. As shown in Figures 5 and 9, in the second switch unit (302), the input end of the second solid-state relay (IC3) is connected to the output end of the second amplification module (20); the output end of the second solid-state relay (IC3) is connected to the second input end of the first amplification module (10); the input control end of the second solid-state relay (IC3) is connected to the control unit (303); and the output control end of the second solid-state relay (IC3) is grounded (GND) or may be grounded (GND) through an eleventh resistor (R11).

It should be noted that the first switch unit (301) and the second switch unit (302) each are not limited to a solid-state relay, which may also be a slide switch and a wire jumper, or may also be an electromagnetic relay, etc. The respective input control ends of the first switch unit (301) and the second switch unit (302) are controlled by an IO pin of a single-chip microcomputer, and the first switch unit (301) and the second switch unit (302) are then controlled by software.

As shown in Figures 6 and 9, the control unit (303) may include: a control signal input end (CNTL-in), a first transistor (Q2), an eighth resistor (R8), and a second transistor (Q3). In specific, the control signal is generated by the single-chip microcomputer, and is inputted to the control unit (303) from the control signal input end (CNTL-in). A control end of the first transistor (Q2) is connected to the control signal input end (CNTL-in); a first end of the first transistor (Q2) is connected to the first switch unit (301), specifically may be connected to the input control end of the first solid-state relay (IC2); and a second end of the first transistor (Q2) is grounded. A first end of the eighth resistor (R8) is connected to a second direct-current voltage source VDD2; and a second end of the eighth resistor (R8) is connected to the first end of the first transistor (Q2). A control end of the second transistor (Q3) is connected to the control signal input end (CNTL-in); a first end of the second transistor (Q3) is connected to a third direct-current voltage source VDD3; and a second end of the second transistor (Q3) is connected to the second switch unit (302), specifically may be connected to the input control end of the second solid-state relay (IC3).

In some embodiments, the control signal may be outputted by the single-chip microcomputer to the control signal input end (CNTL-in), so as to control the first transistor (Q2) and the second transistor (Q3) in the control unit (303) to be disconnected or connected, thus achieving control of the first switch unit (301) and the second switch unit (302), that is: controlling the first switch unit (301) to enable or disenable the first connection between the second end of the first resistor (R1) and the second input end of the first amplification module (10); and controlling the second switch unit (302) to enable or disenable the second connection between the output end of the second amplification module (20) and the second input end of the first amplification module (10).

As such, the control signal outputted by the single-chip microcomputer can be configured through software, thus achieving switch of different functions of the output signal from the output control circuit, thus further achieving intelligentization and remote configuration.

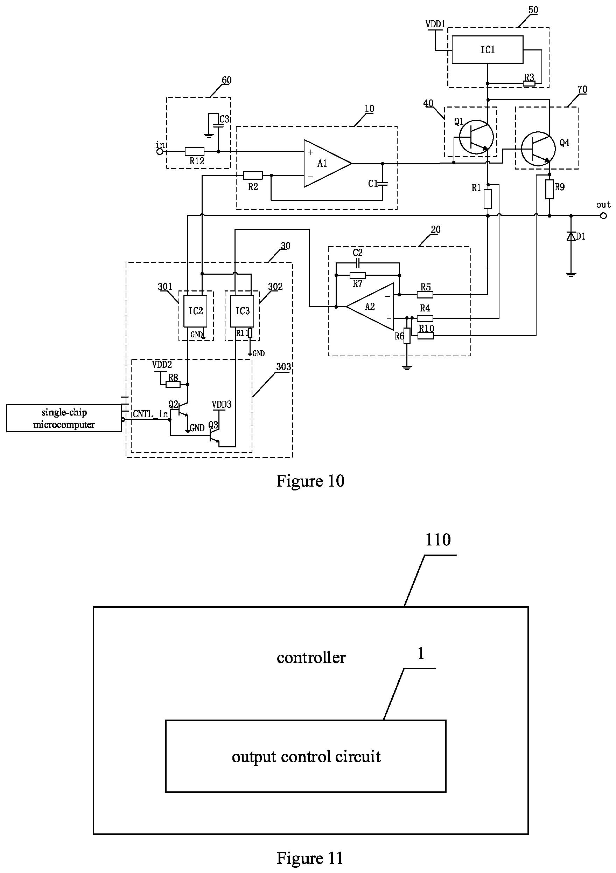

As shown in Figure 10, the output control circuit (1) may further include a diode (D1) connected to the signal output end (out). In specific, a positive electrode of the diode (D1) is grounded (GND), and a negative electrode of the diode (D1) is connected to the signal output end (out). The diode (D1) is configured to absorb a peak voltage generated in response to the first solid-state relay (IC2) or the second solid-state relay (IC3) being disconnected.

As shown in Figures 7 to 10, the output control circuit (1) may further include a filtration module (60) arranged between the first amplification module (10) and the signal input end (in), where the first input end of the first amplification module (10) is connected to the signal input end (in) through the filtration module (60), by which the analog quantity of the voltage input signal is filtered; the filtered analog quantity of the voltage input signal is inputted into the first input end of the first amplification module (10). In specific, the filtration module (60) may include a twelfth resistor (R12) and a third capacitor C3.

According to embodiments of the present disclosure, the output control circuit, by means of the control signal of the control unit (303), controls the first switch unit (301) (specifically may be the first solid-state relay (IC2)) in the switch module (30) to enable or disenable the first connection between the second end of the first resistor (R1) and the second input end of the first amplification module (10); and controls the second switch unit (302) (specifically may be the second solid-state relay (IC3)) to enable or disenable the second connection between the output end of the second amplification module (20) and the second input end of the first amplification module (10).

When the control signal is a low-level signal, both the first transistor (Q2) and the second transistor (Q3) in the control unit (303) are turned off, so that the first switch unit (301) (specifically may be the first solid-state relay (IC2)) are turned on, and the second switch unit (302) (specifically may be the second solid-state relay (IC3)) are turned off, thus enabling the first connection between the second end of the first resistor (R1) and the second input end of the first amplification module (10); while disenabling the second connection between the output end of the second amplification module (20) and the second input end of the first amplification module (10). As shown in Figure 7, in this circumstance, the output control circuit is in a voltage feedback mode.

As an example, when it is required to output the analog quantity of the second voltage output signal (such as the voltage output signal at 0-10 V) from the signal output end (out), the control signal input end (CNTL-in) is inputted with the low-level signal; the voltage input signal inputted from the signal input end (in) is controlled to be the voltage input signal with the analog quantity at 0-10 V; so that the first connection between the second end of the first resistor (R1) and the second input end of the first amplification module (10) is enabled; while the second connection between the output end of the second amplification module (20) and the second input end of the first amplification module (10) is disenabled, accordingly the first amplification module (10) and the first triode (Q1) constitute the emitter follower circuit. Thus, by means of a voltage feedback function, the analog quantity of the second voltage output signal (such as the voltage output signal at 0-10 V) is outputted from the signal output end (out).

As another example, when it is required to output the digital quantity of the first voltage output signal (such as the voltage output signal at 12 V) from the signal output end (out), the control signal input end (CNTL-in) is inputted with the low-level signal; the voltage input signal inputted from the signal input end (in) is controlled to be the voltage input signal with the digital quantity at 12 V; so that the first connection between the second end of the first resistor (R1) and the second input end of the first amplification module (10) is enabled; while the second connection between the output end of the second amplification module (20) and the second input end of the first amplification module (10) is disenabled, accordingly the first amplification module (10) and the first triode (Q1) constitute the emitter follower circuit. Thus, by means of the voltage feedback function, the digital quantity of the first voltage output signal (such as the voltage output signal at 12 V) is outputted from the signal output end (out).

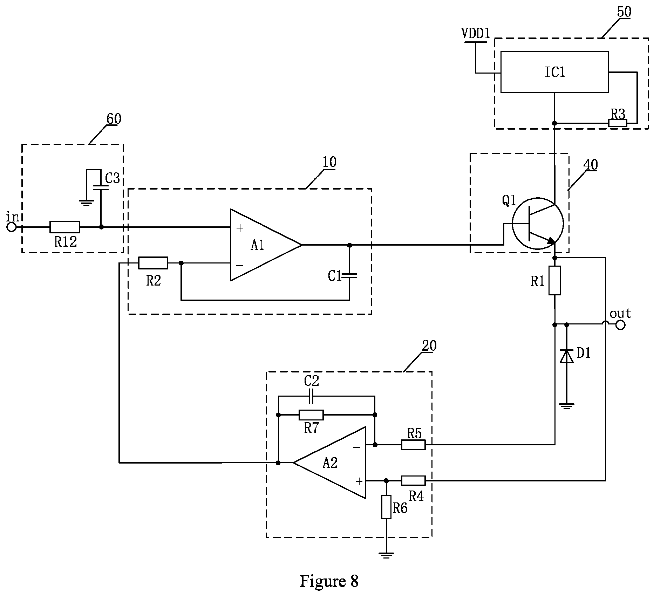

When the control signal is a high-level signal, the first transistor (Q2) and the second transistor (Q3) in the control unit (303) each are turned on, so that the first switch unit (301) (specifically may be the first solid-state relay (IC2)) are turned off, and the second switch unit (302) (specifically may be the second solid-state relay (IC3)) are turned on, thus disenabling the first connection between the second end of the first resistor (R1) and the second input end of the first amplification module (10); and enabling the second connection between the output end of the second amplification module (20) and the second input end of the first amplification module (10). As shown in Figure 8, in this circumstance, the output control circuit is in a current feedback mode.

For example, when it is required to output the analog quantity of the current output signal (such as the current output signal at 0-20 mA) from the signal output end (out), the control signal input end (CNTL-in) is inputted with the high-level signal; the voltage input signal inputted from the signal input end (in) is controlled to be the voltage input signal with the analog quantity at 0-10 V; and the first connection between the second end of the first resistor (R1) and the second input end of the first amplification module (10) is disenabled; while the second connection between the output end of the second amplification module (20) and the second input end of the first amplification module (10) is enabled. In this circumstance, the output control circuit is in the current feedback mode, where the voltage signals across the first resistor (R1) are subjected to differential amplification by passing through the second amplification module (20) (specifically may be the second operational amplifier (A2); and the resulting amplified voltage is required to be consistent with an input voltage corresponding to the voltage input signal. For example, based on that the first resistor (R1), the fourth resistor (R4), the fifth resistor (R5) and the seventh resistor (R7) each are 10 Ω, in response to requiring the signal output end (out) to output a current with the analog quantity at 20 mA, with the input voltage of U=R1 *I*Af=10*0.02* 100/2V=10V, the second amplification module (20) is of an amplification factor is 50-fold; and based on that the first resistor (R1), the fourth resistor (R4), the fifth resistor (R5) and the seventh resistor (R7) each are 5 Ω, the second amplification module (20) is of the amplification factor is 100-fold.

On the basis of the above embodiments, when a single triode (i.e., the first triode (Q1)) is insufficient to drive the desired current, the output control circuit may include two triodes connected in parallel. In an embodiment of the present disclosure as shown in Figure 10, the output control circuit may further include a second power module (70) and a ninth resistor (R9). In specific, the second power module (70) may be composed of a triode or a Metal-Oxide-Semiconductor (MOS) transistor, which is not limited herein particularly. In the embodiment of the present disclosure, the output control circuit is illustrated by taking second triode (Q4) serving as the second power module (70) as an example, where a base electrode of the second triode (Q4) serves as a first end of the second power module (70); a collecting electrode of the second triode (Q4) serves as a second end of the second power module (70); and an emitting electrode of the second triode (Q4)serves as a third end of the second power module (70). A control end (i.e., the base electrode) of the second triode (Q4) is connected to the output end of the first amplification module (10); and a first end (i.e., the collecting electrode) of the second triode (Q4) is connected to the first end (i.e., the collecting electrode) of the first triode (Q1). A first end of the ninth resistor (R9) is connected to a second end (i.e., an emitting electrode) of the second triode (Q4); and a second end of the ninth resistor (R9) is connected to the signal output end (out).

Correspondingly, the second amplification module (20) may further include: a tenth resistor (R10). In specific, a first end of the tenth resistor (R10) is connected to the first end of the ninth resistor (R9); and a second end of the tenth resistor (R10) is connected to the non-inverting input end of the second operational amplifier (A2).

It should be noted that, the output control circuit as shown in Figure 10 operates in a same principle as the output control circuit as shown in Figure 9, which is not elaborated here.

In summary, according to embodiments of the present disclosure, the output control circuit includes: the signal output end, the signal input end, the first amplification module, the first power module, the first resistor, the second amplification module and the switch module; the voltage input signal is inputted from the signal input end; the first input end of the first amplification module is connected to the signal input end; the first end of the first power module is connected to the output end of the first amplification module; the second end of the first power module is connected to the first direct-current voltage source; the first end of the first resistor is connected to the third end of the first power supply; the second end of the first resistor is connected to the signal output end; the first input end of the second amplification module is connected to the first end of the first resistor; the second input end of the second amplification module is connected to the second end of the first resistor; the switch module is connected to the second end of the first resistor, the output end of the second amplification module, and the second input end of the first amplification module, respectively; the switch module is configured to switch between the first connection and the second connection, where the first connection is between the second end of the first resistor and the second input end of the first amplification module, while the second connection is between the output end of the second amplification module and the second input end of the first amplification module; and the digital quantity of the first voltage output signal, the analog quantity of the second voltage output signal, and the analog quantity of the current output signal are outputted from the signal output end. As such, the output control circuit further achieves intelligentization and remote configuration by software control, thus enabling the controller to switch different functions of the output signal, and enhancing universality, safety, and reliability for the output control circuit.

To implement the above embodiments, the present disclosure further provides in embodiments a controller

As shown in Figure 11, the present disclosure provides in embodiments a controller (110), which specifically includes: the output control circuit (1) in any embodiment as described above.

According to embodiments of the present disclosure, the controller further achieves intelligentization and remote configuration by software control, thus enabling the controller to switch different functions of the output signal, and enhancing universality, safety, and reliability for the output control circuit.

To implement the above embodiments, the present disclosure further provides in embodiments an air conditioner (120).

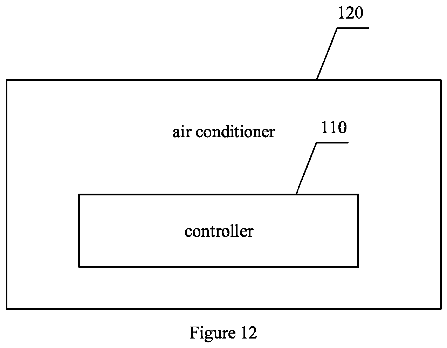

As shown in Figure 12, the present disclosure provides in embodiments an air conditioner (120), which specifically includes the controller (110) as shown in Figure 11.

According to embodiments of the present disclosure, the air conditioner further achieves intelligentization and remote configuration by software control, thus enabling the controller to switch different functions of the output signal, and enhancing universality, safety, and reliability for the output control circuit.

## Claims

1. An output control circuit (1) for a controller, wherein the output control circuit (1) is configured to be arranged in the controller (110), and the output control circuit (1) comprises:
a signal input end, configured to input a voltage input signal;
a first amplification module (10), wherein a first input end of the first amplification module (10) is connected to the signal input end;
a first power module (40), wherein a first end of the first power module (40) is connected to an output end of the first amplification module (10); and a second end of the first power module (40) is connectable to a first direct-current voltage source;
a first resistor (R1), wherein a first end of the first resistor (R1)is connected to a third end of the first power module (40);
a second amplification module (20), wherein a first input end of the second amplification module (20) is connected to the first end of the first resistor; (R1) and a second input end of the second amplification module (20) is connected to a second end of the first resistor (R1);
a switch module (30), wherein the switch module (30) is connected to the second end of the first resistor (R1), an output end of the second amplification module (20), and a second input end of the first amplification module (10), respectively; and the switch module (30) is configured to switch between a first connection and a second connection, wherein the first connection is between the second end of the first resistor (R1) and the second input end of the first amplification module (10); and the second connection is between the output end of the second amplification module (20) and the second input end of the first amplification module (10); and
a signal output end, wherein the signal output end is connected to the second end of the first resistor (R1), and configured to output a digital quantity of a first voltage output signal, an analog quantity of a second voltage output signal, and an analog quantity of a current output signal.

2. The output control circuit (1) according to claim 1, wherein the first amplification module (10) comprises:
a first operational amplifier, wherein a non-inverting input end of the first operational amplifier is connected to the signal input end; and an output end of the first operational amplifier is connected to the first end of the first power module (40);
a first capacitor, wherein a first end of the first capacitor is connected to the output end of the first operational amplifier, and a second end of the first capacitor is connected to an inverting input end of the first operational amplifier; and
a second resistor (R2), wherein a first end of the second resistor (R2) is connected to the inverting input end of the first operational amplifier, and a second end of the second resistor (R2) is connected to the switch module (30).

3. The output control circuit (1) according to claim 1 or 2, further comprising an overcurrent protection module (50), wherein the second end of the first power module (40) is connectable to the first direct-current voltage source through the overcurrent protection module (50).

4. The output control circuit (1) according to claim 3, wherein the overcurrent protection module (50) comprises:
a voltage stabilizer or current limiter, wherein a first end of the voltage stabilizer or current limiter is connectable to the first direct-current voltage source; and a second end of the voltage stabilizer or current limiter is connected to the second end of the first power module (40); and
a third resistor (R3), wherein the second end of the voltage stabilizer or current limiter is connected to a third end of the voltage stabilizer or current limiter through the third resistor (R3).

5. The output control circuit (1) according to any one of claims 1 to 4, wherein the second amplification module (20) comprises:
a fourth resistor (R4);
a fifth resistor (R5);
a second operational amplifier, wherein a non-inverting input end of the second operational amplifier is connected to the first end of the first resistor (R1)through the fourth resistor (R4); an inverting input end of the second operational amplifier is connected to the second end of the first resistor (R1) through the fifth resistor (R5); and an output end of the second operational amplifier is connected to the switch module (30);
a sixth resistor (R6), wherein a first end of the sixth resistor (R6) is grounded; a second end of the sixth resistor (R6) is connected to the non-inverting input end of the second operational amplifier;
a seventh resistor (R7), wherein a first end of the seventh resistor (R7) is connected to the output end of the second operational amplifier; and a second end of the seventh resistor (R7) is connected to the inverting input end of the second operational amplifier; and
a second capacity, wherein a first end of the second capacitor is connected to the output end of the second operational amplifier; and a second end of the second capacitor is connected to the inverting input end of the second operational amplifier.

6. The output control circuit (1) according to any one of claims 1 to 5, wherein the switch module (30) comprises:
a first switch unit (301), wherein the first switch unit (301) is connected to the second end of the first resistor (R1) and the second input end of the first amplification module (10), respectively;
a second switch unit (302), wherein the second switch unit (302) is connected to the output end of the second amplification module (20) and the second input end of the first amplification module (10), respectively; and
a control unit (303), wherein the control unit (303) is connected to the first switch unit (301) and the second switch unit (302), respectively; the control unit (303) is configured to: in response to a control signal inputted,
control the first switch unit (301) to enable or disenable the first connection between the second end of the first resistor (R1)and the second input end of the first amplification module (10); or
control the second switch unit (302) to enable or disenable the second connection between the output end of the second amplification module (20) and the second input end of the first amplification module (10).

7. The output control circuit (1) according to claim 6, wherein the first switch unit (301) comprises a first solid-state relay, wherein an input end of the first solid-state relay is connected to the second end of the first resistor (R1); an output end of the first solid-state relay is connected to the second input end of the first amplification module (10); an input control end of the first solid-state relay is connected to the control unit (303); and an output control end of the first solid-state relay is grounded.

8. The output control circuit (1) according to claim 6 or 7, wherein the second switch unit (302) comprises a second solid-state relay, wherein an input end of the second solid-state relay is connected to the output end of the second amplification module (20); an output end of the second solid-state relay is connected to the second input end of the first amplification module (10); an input control end of the second solid-state relay is connected to the control unit (303); and an output control end of the second solid-state relay is grounded.

9. The output control circuit (1) according to any one of claims 6 to 8, wherein the control unit (303) comprises:
a control signal input end, configured to input the control signal;
a first transistor, wherein a control end of the first transistor is connected to the control signal input end; a first end of the first transistor is connected to the first switch unit (301); and a second end of the first transistor is grounded;
an eighth resistor (R8), wherein a first end of the eighth resistor (R8) is connectable to a second direct-current voltage source; and a second end of the eighth resistor (R8) is connected to the first end of the first transistor; and
a second transistor, wherein a control end of the second transistor is connected to the control signal input end; a first end of the second transistor is connectable to a third direct-current voltage source; and a second end of the second transistor is connected to the second switch unit (302).

10. The output control circuit (1) according to any one of claims 1 to 9, further comprising a diode, wherein a positive electrode of the diode is grounded; and a negative electrode of the diode is connected to the signal output end.

11. The output control circuit (1) according to any one of claims 1 to 10, further comprising a filtration module (60), wherein the first input end of the first amplification module (10) is connected to the signal input end through the filtration module (60).

12. The output control circuit (1) according to any one of claims 5 to 11, further comprising:
a second power module (70), wherein a first end of the second power module (70) is connected to the output end of the first amplification module (10); and a second end of the second power module (70) is connected to the second end of the first power module (40); and
a ninth resistor (R9), wherein a first end of the ninth resistor (R9) is connected to a third end of the second power module (70); and a second end of the ninth resistor (R9) is connected to the signal output end,
wherein the second amplification module (20) further comprises:
a tenth resistor (R10), wherein a first end of the tenth resistor (R10) is connected to the first end of the ninth resistor (R9); and a second end of the tenth resistor (R10) is connected to the non-inverting input end of the second operational amplifier.

13. A controller (110), comprising an output control circuit (1) for a controller according to any one of claims 1 to 12.

14. An air conditioner (120), comprising a controller (110) according to claim 13.

## Patentansprüche

1. Ausgangssteuerschaltung (1) für eine Steuerung, wobei die Ausgangssteuerschaltung (1) dazu konfiguriert ist, in der Steuerung (110) angeordnet zu sein, und die Ausgangssteuerschaltung (1) Folgendes umfasst:
ein Signaleingangsende, das dazu konfiguriert ist, ein Spannungseingangssignal einzugeben;
ein erstes Verstärkungsmodul (10), wobei ein erstes Eingangsende des ersten Verstärkungsmoduls (10) mit dem Signaleingangsende verbunden ist;
ein erstes Leistungsmodul (40), wobei ein erstes Ende des ersten Leistungsmoduls (40) mit einem Ausgangsende des ersten Verstärkungsmoduls (10) verbunden ist; und ein zweites Ende des ersten Leistungsmoduls (40) mit einer ersten Gleichspannungsquelle verbindbar ist;
einen ersten Widerstand (R1), wobei ein erstes Ende des ersten Widerstands (R1) mit einem dritten Ende des ersten Leistungsmoduls (40) verbunden ist;
ein zweites Verstärkungsmodul (20), wobei ein erstes Eingangsende des zweiten Verstärkungsmoduls (20) mit dem ersten Ende des ersten Widerstands (R1) verbunden ist und ein zweites Eingangsende des zweiten Verstärkungsmoduls (20) mit einem zweiten Ende des ersten Widerstands (R1) verbunden ist;
ein Schaltmodul (30), wobei das Schaltmodul (30) mit dem zweiten Ende des ersten Widerstands (R1), einem Ausgangsende des zweiten Verstärkungsmoduls (20) bzw. einem zweiten Eingangsende des ersten Verstärkungsmoduls (10) verbunden ist; und das Schaltmodul (30) dazu konfiguriert ist, zwischen einer ersten Verbindung und einer zweiten Verbindung umzuschalten, wobei die erste Verbindung sich zwischen dem zweiten Ende des ersten Widerstands (R1) und dem zweiten Eingangsende des ersten Verstärkungsmoduls (10) befindet; und die zweite Verbindung sich zwischen dem Ausgangsende des zweiten Verstärkungsmoduls (20) und dem zweiten Eingangsende des ersten Verstärkungsmoduls (10) befindet; und
ein Signalausgangsende, wobei das Signalausgangsende mit dem zweiten Ende des ersten Widerstands (R1) verbunden und dazu konfiguriert ist, einen Digitalwert eines ersten Spannungsausgangssignals, einen Analogwert eines zweiten Spannungsausgangssignals und einen Analogwert eines Stromausgangssignals auszugeben.

2. Ausgangssteuerschaltung (1) nach Anspruch 1, wobei das erste Verstärkungsmodul (10) Folgendes umfasst:
einen ersten Operationsverstärker, wobei ein nichtinvertierendes Eingangsende des ersten Operationsverstärkers mit dem Signaleingangsende verbunden ist; und ein Ausgangsende des ersten Operationsverstärkers mit dem ersten Ende des ersten Leistungsmoduls (40) verbunden ist;
einen ersten Kondensator, wobei ein erstes Ende des ersten Kondensators mit dem Ausgangsende des ersten Operationsverstärkers verbunden ist und ein zweites Ende des ersten Kondensators mit einem invertierenden Eingangsende des ersten Operationsverstärkers verbunden ist; und
einen zweiten Widerstand (R2), wobei ein erstes Ende des zweiten Widerstands (R2) mit dem invertierenden Eingangsende des ersten Operationsverstärkers verbunden ist und ein zweites Ende des zweiten Widerstands (R2) mit dem Schaltmodul (30) verbunden ist.

3. Ausgangssteuerschaltung (1) nach Anspruch 1 oder 2, die ferner ein Überstromschutzmodul (50) umfasst, wobei das zweite Ende des ersten Leistungsmoduls (40) durch das Überstromschutzmodul (50) mit der ersten Gleichspannungsquelle verbindbar ist.

4. Ausgangssteuerschaltung (1) nach Anspruch 3, wobei das Überstromschutzmodul (50) Folgendes umfasst:
einen Spannungsstabilisator oder Strombegrenzer, wobei ein erstes Ende des Spannungsstabilisators oder Strombegrenzers mit der ersten Gleichspannungsquelle verbindbar ist; und ein zweites Ende des Spannungsstabilisators oder Strombegrenzers mit dem zweiten Ende des ersten Leistungsmoduls (40) verbunden ist; und
einen dritten Widerstand (R3), wobei das zweite Ende des Spannungsstabilisators oder Strombegrenzers durch den dritten Widerstand (R3) mit einem dritten Ende des Spannungsstabilisators oder Strombegrenzers verbunden ist.

5. Ausgangssteuerschaltung (1) nach einem der Ansprüche 1 bis 4, wobei das zweite Verstärkungsmodul (20) Folgendes umfasst:
einen vierten Widerstand (R4);
einen fünften Widerstand (R5);
einen zweiten Operationsverstärker, wobei ein nichtinvertierendes Eingangsende des zweiten Operationsverstärkers durch den vierten Widerstand (R4) mit dem ersten Ende des ersten Widerstands (R1) verbunden ist; ein invertierendes Eingangsende des zweiten Operationsverstärkers durch den fünften Widerstand (R5) mit dem zweiten Ende des ersten Widerstands (R1) verbunden ist; und ein Ausgangsende des zweiten Operationsverstärkers mit dem Schaltmodul (30) verbunden ist;
einen sechsten Widerstand (R6), wobei ein erstes Ende des sechsten Widerstands (R6) mit Masse verbunden ist; ein zweites Ende des sechsten Widerstands (R6) mit dem nichtinvertierenden Eingangsende des zweiten Operationsverstärkers verbunden ist;
einen siebten Widerstand (R7), wobei ein erstes Ende des siebten Widerstands (R7) mit dem Ausgangsende des zweiten Operationsverstärkers verbunden ist; und ein zweites Ende des siebten Widerstands (R7) mit dem invertierenden Eingangsende des zweiten Operationsverstärkers verbunden ist; und
einen zweiten Kondensator, wobei ein erstes Ende des zweiten Kondensators mit dem Ausgangsende des zweiten Operationsverstärkers verbunden ist; und ein zweites Ende des zweiten Kondensators mit dem invertierenden Eingangsende des zweiten Operationsverstärkers verbunden ist.

6. Ausgangssteuerschaltung (1) nach einem der Ansprüche 1 bis 5, wobei das Schaltmodul (30) Folgendes umfasst:
eine erste Schalteinheit (301), wobei die erste Schalteinheit (301) mit dem zweiten Ende des ersten Widerstands (R1) bzw. dem zweiten Eingangsende des ersten Verstärkungsmoduls (10) verbunden ist;
eine zweite Schalteinheit (302), wobei die zweite Schalteinheit (302) mit dem Ausgangsende des zweiten Verstärkungsmoduls (20) bzw. dem zweiten Eingangsende des ersten Verstärkungsmoduls (10) verbunden ist; und
eine Steuereinheit (303), wobei die Steuereinheit (303) mit der ersten Schalteinheit (301) bzw. der zweiten Schalteinheit (302) verbunden ist; die Steuereinheit (303) zu Folgendem konfiguriert ist: als Reaktion auf ein eingegebenes Steuersignal
Steuern der ersten Schalteinheit (301), um die erste Verbindung zwischen dem zweiten Ende des ersten Widerstands (R1) und dem zweiten Eingangsende des ersten Verstärkungsmoduls (10) einzuschalten oder auszuschalten; oder
Steuern der zweiten Schalteinheit (302), um die zweite Verbindung zwischen dem Ausgangsende des zweiten Verstärkungsmoduls (20) und dem zweiten Eingangsende des ersten Verstärkungsmoduls (10) einzuschalten oder auszuschalten.

7. Ausgangssteuerschaltung (1) nach Anspruch 6, wobei die erste Schalteinheit (301) ein erstes Halbleiterrelais umfasst, wobei ein Eingangsende des ersten Halbleiterrelais mit dem zweiten Ende des ersten Widerstands (R1) verbunden ist; ein Ausgangsende des ersten Halbleiterrelais mit dem zweiten Eingangsende des ersten Verstärkungsmoduls (10) verbunden ist; ein Eingangssteuerende des ersten Halbleiterrelais mit der Steuereinheit (303) verbunden ist; und ein Ausgangssteuerende des ersten Halbleiterrelais mit Masse verbunden ist.

8. Ausgangssteuerschaltung (1) nach Anspruch 6 oder 7, wobei die zweite Schalteinheit (302) ein zweites Halbleiterrelais umfasst, wobei ein Eingangsende des zweiten Halbleiterrelais mit dem Ausgangsende des zweiten Verstärkungsmoduls (20) verbunden ist; ein Ausgangsende des zweiten Halbleiterrelais mit dem zweiten Eingangsende des ersten Verstärkungsmoduls (10) verbunden ist; ein Eingangssteuerende des zweiten Halbleiterrelais mit der Steuereinheit (303) verbunden ist; und ein Ausgangssteuerende des zweiten Halbleiterrelais mit Masse verbunden ist.

9. Ausgangssteuerschaltung (1) nach einem der Ansprüche 6 bis 8, wobei die Steuereinheit (303) Folgendes umfasst:
ein Steuersignaleingangsende, das dazu konfiguriert ist, das Steuersignal einzugeben;
einen ersten Transistor, wobei ein Steuerende des ersten Transistors mit dem Steuersignaleingangsende verbunden ist; ein erstes Ende des ersten Transistors mit der ersten Schalteinheit (301) verbunden ist; und ein zweites Ende des ersten Transistors mit Masse verbunden ist;
einen achten Widerstand (R8), wobei ein erstes Ende des achten Widerstands (R8) mit einer zweiten Gleichspannungsquelle verbindbar ist; und ein zweites Ende des achten Widerstands (R8) mit dem ersten Ende des ersten Transistors verbunden ist; und
einen zweiten Transistor, wobei ein Steuerende des zweiten Transistors mit dem Steuersignaleingangsende verbunden ist; ein erstes Ende des zweiten Transistors mit einer dritten Gleichspannungsquelle verbindbar ist; und ein zweites Ende des zweiten Transistors mit der zweiten Schalteinheit (302) verbunden ist.

10. Ausgangssteuerschaltung (1) nach einem der Ansprüche 1 bis 9, die ferner eine Diode umfasst, wobei eine positive Elektrode der Diode mit Masse verbunden ist; und eine negative Elektrode der Diode mit dem Signalausgangsende verbunden ist.

11. Ausgangssteuerschaltung (1) nach einem der Ansprüche 1 bis 10, die ferner ein Filtermodul (60) umfasst, wobei das erste Eingangsende des ersten Verstärkungsmoduls (10) durch das Filtermodul (60) mit dem Signaleingangsende verbunden ist.

12. Ausgangssteuerschaltung (1) nach einem der Ansprüche 5 bis 11, die ferner Folgendes umfasst:
ein zweites Leistungsmodul (70), wobei ein erstes Ende des zweiten Leistungsmoduls (70) mit dem Ausgangsende des ersten Verstärkungsmoduls (10) verbunden ist; und ein zweites Ende des zweiten Leistungsmoduls (70) mit dem zweiten Ende des ersten Leistungsmoduls (40) verbunden ist; und
einen neunten Widerstand (R9), wobei ein erstes Ende des neunten Widerstands (R9) mit einem dritten Ende des zweiten Leistungsmoduls (70) verbunden ist; und ein zweites Ende des neunten Widerstands (R9) mit dem Signalausgangsende verbunden ist,
wobei das zweite Verstärkungsmodul (20) ferner Folgendes umfasst:
einen zehnten Widerstand (R10), wobei ein erstes Ende des zehnten Widerstands (R10) mit dem ersten Ende des neunten Widerstands (R9) verbunden ist; und ein zweites Ende des zehnten Widerstands (R10) mit dem nichtinvertierenden Eingangsende des zweiten Operationsverstärkers verbunden ist.

13. Steuerung (110), die eine Ausgangssteuerschaltung (1) für eine Steuerung nach einem der Ansprüche 1 bis 12 umfasst.

14. Klimaanlage (120), die eine Steuerung (110) nach Anspruch 13 umfasst.

## Revendications

1. Circuit de commande de sortie (1) pour un dispositif de commande, dans lequel le circuit de commande de sortie (1) est configuré pour être agencé dans le dispositif de commande (110), et le circuit de commande de sortie (1) comprend :
une extrémité d'entrée de signal, configurée pour entrer un signal d'entrée de tension ;
un premier module d'amplification (10), dans lequel une première extrémité d'entrée du premier module d'amplification (10) est connectée à l'extrémité d'entrée de signal ;
un premier module d'alimentation (40), dans lequel une première extrémité du premier module d'alimentation (40) est connectée à une extrémité de sortie du premier module d'amplification (10) ; et une deuxième extrémité du premier module d'alimentation (40) peut être connectée à une première source de tension continue ;
une première résistance (R1), dans lequel une première extrémité de la première résistance (R1) est connectée à une troisième extrémité du premier module d'alimentation (40) ;
un second module d'amplification (20), dans lequel une première extrémité d'entrée du second module d'amplification (20) est connectée à la première extrémité de la première résistance (R1) ; et une deuxième extrémité d'entrée du second module d'amplification (20) est connectée à une deuxième extrémité de la première résistance (R1) ;
un module de commutation (30), dans lequel le module de commutation (30) est connecté respectivement à la deuxième extrémité de la première résistance (R1), à l'extrémité de sortie du second module d'amplification (20), et à une deuxième extrémité d'entrée du premier module d'amplification (10) ; et le module de commutation (30) est configuré pour commuter entre une première connexion et une seconde connexion, dans lequel la première connexion est entre la deuxième extrémité de la première résistance (R1) et la deuxième extrémité d'entrée du premier module d'amplification (10) ; et la seconde connexion est entre l'extrémité de sortie du second module d'amplification (20) et la deuxième extrémité d'entrée du premier module d'amplification (10) ; et
une extrémité de sortie de signal, dans lequel l'extrémité de sortie de signal est connectée à la deuxième extrémité de la première résistance (R1), et configurée pour sortir une quantité numérique d'un premier signal de sortie de tension, une quantité analogique d'un second signal de sortie de tension, et une quantité analogique d'un signal de sortie de courant.

2. Circuit de commande de sortie (1) selon la revendication 1, dans lequel le premier module d'amplification (10) comprend :
un premier amplificateur opérationnel, dans lequel une extrémité d'entrée non-inverseuse du premier amplificateur opérationnel est connectée à l'extrémité d'entrée de signal ; et une extrémité de sortie du premier amplificateur opérationnel est connectée à la première extrémité du premier module d'alimentation (40) ;
un premier condensateur, dans lequel une première extrémité du premier condensateur est connectée à l'extrémité de sortie du premier amplificateur opérationnel, et une deuxième extrémité du premier condensateur est connectée à une extrémité d'entrée inverseuse du premier amplificateur opérationnel ; et
une deuxième résistance (R2), dans lequel une première extrémité de la deuxième résistance (R2) est connectée à l'extrémité d'entrée inverseuse du premier amplificateur opérationnel, et une deuxième extrémité de la deuxième résistance (R2) est connectée au module de commutation (30).

3. Circuit de commande de sortie (1) selon la revendication 1 ou 2, comprenant en outre un module de protection contre les surintensités (50), dans lequel la deuxième extrémité du premier module d'alimentation (40) peut être connectée à la première source de tension continue à travers le module de protection contre les surintensités (50).

4. Circuit de commande de sortie (1) selon la revendication 3, dans lequel le module de protection contre les surintensités (50) comprend :
un stabilisateur de tension ou limiteur de courant, dans lequel une première extrémité du stabilisateur de tension ou du limiteur de courant peut être connectée à la première source de tension continue ; et une deuxième extrémité du stabilisateur de tension ou du limiteur de courant est connectée à la deuxième extrémité du premier module d'alimentation (40) ; et
une troisième résistance (R3), dans lequel la deuxième extrémité du stabilisateur de tension ou du limiteur de courant est connectée à une troisième extrémité du stabilisateur de tension ou du limiteur de courant à travers la troisième résistance (R3).

5. Circuit de commande de sortie (1) selon l'une quelconque des revendications 1 à 4, dans lequel le second module d'amplification (20) comprend :
une quatrième résistance (R4) ;
une cinquième résistance (R5) ;
un second amplificateur opérationnel, dans lequel une extrémité d'entrée non-inverseuse du second amplificateur opérationnel est connectée à la première extrémité de la première résistance (R1) à travers la quatrième résistance (R4) ; une extrémité d'entrée inverseuse du second amplificateur opérationnel est connectée à la deuxième extrémité de la première résistance (R1) à travers la cinquième résistance (R5) ; et une extrémité de sortie du second amplificateur opérationnel est connectée au module de commutation (30) ;
une sixième résistance (R6), dans lequel une première extrémité de la sixième résistance (R6) est mise à la masse ; une deuxième extrémité de la sixième résistance (R6) est connectée à l'extrémité d'entrée non-inverseuse du second amplificateur opérationnel ;
une septième résistance (R7), dans lequel une première extrémité de la septième résistance (R7) est connectée à l'extrémité de sortie du second amplificateur opérationnel ; et une deuxième extrémité de la septième résistance (R7) est connectée à l'extrémité d'entrée inverseuse du second amplificateur opérationnel ; et
un second condensateur, dans lequel une première extrémité du second condensateur est connectée à l'extrémité de sortie du second amplificateur opérationnel ; et une deuxième extrémité du second condensateur est connectée à l'extrémité d'entrée inverseuse du second amplificateur opérationnel.

6. Circuit de commande de sortie (1) selon l'une quelconque des revendications 1 à 5, dans lequel le module de commutation (30) comprend :
une première unité de commutation (301), dans lequel la première unité de commutation (301) est connectée respectivement à la deuxième extrémité de la première résistance (R1) et à la deuxième extrémité d'entrée du premier module d'amplification (10) ;
une seconde unité de commutation (302), dans lequel la seconde unité de commutation (302) est connectée respectivement à l'extrémité de sortie du second module d'amplification (20) et à la deuxième extrémité d'entrée du premier module d'amplification (10) ; et
une unité de commande (303), dans lequel l'unité de commande (303) est connectée respectivement à la première unité de commutation (301) et à la seconde unité de commutation (302) ; l'unité de commande (303) étant configurée pour : en réponse à un signal de commande entré,
commander la première unité de commutation (301) pour activer ou désactiver la première connexion entre la deuxième extrémité de la première résistance (R1) et la deuxième extrémité d'entrée du premier module d'amplification (10) ; ou
commander la seconde unité de commutation (302) pour activer ou désactiver la seconde connexion entre l'extrémité de sortie du second module d'amplification (20) et la deuxième extrémité d'entrée du premier module d'amplification (10).

7. Circuit de commande de sortie (1) selon la revendication 6, dans lequel la première unité de commutation (301) comprend un premier relais à semi-conducteurs, dans lequel une extrémité d'entrée du premier relais à semi-conducteurs est connectée à la deuxième extrémité de la première résistance (R1) ; une extrémité de sortie du premier relais à semi-conducteurs est connectée à la deuxième extrémité d'entrée du premier module d'amplification (10) ; une extrémité de commande d'entrée du premier relais à semi-conducteurs est connectée à l'unité de commande (303) ; et une extrémité de commande de sortie du premier relais à semi-conducteurs est mise à la masse.

8. Circuit de commande de sortie (1) selon la revendication 6 ou 7, dans lequel la seconde unité de commutation (302) comprend un second relais à semi-conducteurs, dans lequel une extrémité d'entrée du second relais à semi-conducteurs est connectée à l'extrémité de sortie du second module d'amplification (20) ; une extrémité de sortie du second relais à semi-conducteurs est connectée à la deuxième extrémité d'entrée du premier module d'amplification (10) ; une extrémité de commande d'entrée du second relais à semi-conducteurs est connectée à l'unité de commande (303) ; et une extrémité de commande de sortie du second relais à semi-conducteurs est mise à la masse.

9. Circuit de commande de sortie (1) selon l'une quelconque des revendications 6 à 8, dans lequel l'unité de commande (303) comprend :
une extrémité d'entrée de signal de commande, configurée pour entrer le signal de commande ;
un premier transistor, dans lequel une extrémité de commande du premier transistor est connectée à l'extrémité d'entrée du signal de commande ; une première extrémité du premier transistor est connectée à la première unité de commutation (301) ; et une deuxième extrémité du premier transistor est mise à la masse ;
une huitième résistance (R8), dans lequel une première extrémité de la huitième résistance (R8) peut être connectée à une seconde source de tension continue ; et une deuxième extrémité de la huitième résistance (R8) est connectée à la première extrémité du premier transistor ; et
un second transistor, dans lequel une extrémité de commande du second transistor est connectée à l'extrémité d'entrée de signal de commande ; une première extrémité du second transistor peut être connectée à une troisième source de tension continue ; et une deuxième extrémité du second transistor est connectée à la seconde unité de commutation (302).

10. Circuit de commande de sortie (1) selon l'une quelconque des revendications 1 à 9, comprenant en outre une diode, dans lequel une électrode positive de la diode est mise à la masse ; et une électrode négative de la diode est connectée à l'extrémité de sortie de signal.

11. Circuit de commande de sortie (1) selon l'une quelconque des revendications 1 à 10, comprenant en outre un module de filtration (60), dans lequel la première extrémité d'entrée du premier module d'amplification (10) est connectée à l'extrémité d'entrée de signal à travers le module de filtration (60).

12. Circuit de commande de sortie (1) selon l'une quelconque des revendications 5 à 11, comprenant en outre :
un second module d'alimentation (70), dans lequel une première extrémité du second module d'alimentation (70) est connectée à l'extrémité de sortie du premier module d'amplification (10) ; et une deuxième extrémité du second module d'alimentation (70) est connectée à la deuxième extrémité du premier module d'alimentation (40) ; et
une neuvième résistance (R9), dans lequel une première extrémité de la neuvième résistance (R9) est connectée à une troisième extrémité du second module d'alimentation (70) ; et une deuxième extrémité de la neuvième résistance (R9) est connectée à l'extrémité de sortie de signal,
dans lequel le second module d'amplification (20) comprend en outre :
une dixième résistance (R10), dans lequel une première extrémité de la dixième résistance (R10) est connectée à la première extrémité de la neuvième résistance (R9) ; et une deuxième extrémité de la dixième résistance (R10) est connectée à l'extrémité d'entrée non-inverseuse du second amplificateur opérationnel.

13. Dispositif de commande (110), comprenant un circuit de commande de sortie (1) pour un dispositif de commande selon l'une quelconque des revendications 1 à 12.

14. Climatiseur (120), comprenant un dispositif de commande (110) selon la revendication 13.
